# FASCICULE DE BREVET EUROPEEN

(11) **EP 0 975 018 B1**
(45) Date de publication et mention de la délivrance du brevet: **22.04.2009**
(21) Numéro de dépôt: 99410087.3
(22) Date de dépôt: 20.07.1999
(51) Int. Cl.: H01L 21/3205

(54) **Procédé de formation d'une capacité sur un circuit intégré**
Methode zur Herstellung eines Kondensators in einer integrierten Schaltung
Method of forming a capacitor within an integrated circuit

(30) Priorité: 21.07.1998 FR 9809437
(43) Date de publication de la demande: 26.01.2000
(73) Titulaire: Koninklijke Philips Electronics N.V., 5621 BA Eindhoven (NL)
(72) Inventeur: Gris, Yvon, 38210 Tullins (FR); Troillard, Germaine, 38660 Le Touvet (FR); Mourier, Jocelyne, 38120 Saint Egrève (FR); Guelen, Jos, 38920 Crolles (FR); Lunardi, Geneviève, 38240 Meylan (FR); Banvillet, Henri, 38190 Froges (FR); Oberlin, Jean-Claude, 38660 Le Touvet (FR); Maddalon, Catherine, 38120 Saint Egrève (FR)
(74) Mandataire: van der Veer, Johannis Leendert

(56) Documents cités:
- WO-A-96/17386
- WO-A-98/05071
- PATENT ABSTRACTS OF JAPAN vol. 018, no. 171 (E-1529), 23 mars 1994 (1994-03-23) & JP 05 343613 A (YAMAHA CORP), 24 décembre 1993 (1993-12-24)

## Description

La présente invention concerne le domaine de la fabrication de circuits intégrés, et plus particulièrement de capacités adaptées à fonctionner à haute fréquence (au-dessus du gigahertz), c'est-à-dire présentant une faible résistance d'accès et une faible capacité parasite avec des éléments du substrat.

Un circuit intégré comprend diverses couches et régions de divers niveaux de dopage formées dans un substrat semiconducteur, couramment du silicium. Généralement, notamment dans les technologies de type MOS, il est prévu un niveau de silicium polycristallin, et quelques fois plusieurs, pour former notamment la ou les grilles de transistors MOS ou de points mémoire. Plusieurs niveaux de métallisation sont destinés à assurer les interconnexions.

Chaque formation d'une couche conductrice, silicium polycristallin dopé ou métal, est suivie du dépôt d'au moins une couche isolante pour que, aux emplacements où on le souhaite, la couche conductrice suivante puisse être isolée de la couche sous-jacente.

Ainsi, il est possible de former une capacité chaque fois qu'il existe deux couches conductrices déposées successivement et séparées par une couche isolante.

Pour former des capacités destinées à fonctionner à haute fréquence, à faible résistance d'accès et à faible capacité parasite avec des éléments du composant semiconducteur, il faut éviter d'utiliser des capacités dont l'une des plaques est constituée d'une région semiconductrice ainsi que des capacités dont l'une des plaques est constituée de silicium polycristallin. En effet, dans les deux cas, on trouve des résistances d'accès relativement élevées et un couplage capacitif relativement fort avec des éléments du substrat semiconducteur. On est donc amené à utiliser des capacités entre métallisations qui se trouvent plus éloignées du substrat et pour lesquelles la résistance d'accès est faible, les métallisations étant généralement meilleures conductrices que le silicium mono ou polycristallin dopé.

Toutefois, pratiquement toutes les capacités connues entre niveaux de métallisation présentent divers inconvénients. Souvent, le deuxième métal est gravé alors qu'une couche mince d'un isolant a été déposée. Il en résulte que, lors de la gravure du métal, l'isolant mince peut être endommagé ce qui risque de le fragiliser et d'entraîner des claquages. Dans de nombreuses solutions, il faut prévoir plusieurs étapes de masquage et de gravure supplémentaires par rapport à celles existant dans un procédé classique. Il existe également des problèmes de fiabilité au niveau des flancs des capacités. En outre, dans le cas où l'on utilise pour l'un des métaux de l'aluminium, il apparaît des problèmes liés aux pénétrations par pointes de l'aluminium dans les couches voisines.

Ainsi, un objet de la présente invention est de prévoir un procédé de fabrication d'une capacité entre niveaux de métallisation qui évite un ou plusieurs des inconvénients ci-dessus.

Un objet plus particulier de la présente invention est de prévoir un tel procédé qui soit compatible avec des filières classiques de fabrication de composants CMOS.

Un autre objet de la présente invention est de prévoir un tel procédé qui ne rajoute pratiquement pas d'étape aux étapes de fabrication normales d'un composant de type CMOS.

Pour atteindre ces objets, la présente invention prévoit un procédé de fabrication d'un condensateur dans des niveaux de métallisation d'un circuit intégré comprenant les étapes consistant à déposer un premier niveau de métal et graver ce premier niveau de métal pour laisser en place au moins une région correspondant à une première plaque d'un condensateur et au moins une zone de contact correspondant à une connexion avec laquelle on veut établir un contact supérieur ; déposer une couche isolante entre niveaux de métallisation ; former une première ouverture au-dessus de la première plaque de condensateur ; déposer une couche isolante mince ; former une deuxième ouverture au-dessus de la zone de contact ; déposer un deuxième niveau de métal de façon à remplir complètement la deuxième ouverture ; procéder à une gravure physico-chimique pour éliminer la deuxième couche de métal en dehors des régions où elle remplit les ouvertures ; déposer un troisième niveau de métal et laisser en place des portions de ce troisième niveau de métal au-dessus de ladite région de condensateur et de ladite zone de contact.

Selon un mode de réalisation de la présente invention, les premier et deuxième niveaux de métal sont en tungstène.

Selon un mode de réalisation de la présente invention, la première ouverture est réalisée de façon à présenter des flancs inclinés tandis que la deuxième ouverture est réalisée de façon à présenter des flancs raides.

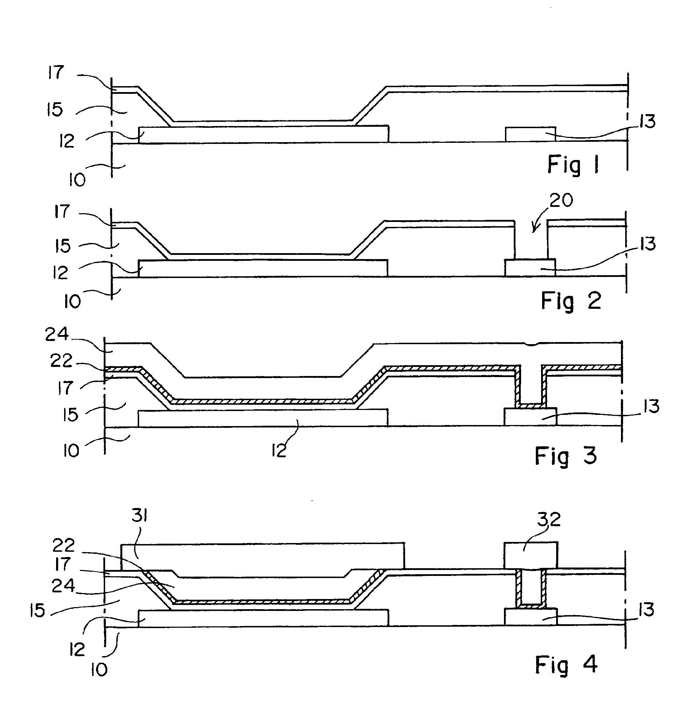

Ces objets, caractéristiques et avantages, ainsi que d'autres de la présente invention seront exposés en détail dans la description suivante de modes de réalisation particuliers faite à titre non-limitatif en relation avec les figures 1 à 4 qui illustrent des étapes successives de fabrication d'un composant selon la présente invention.

Un exemple de réalisation du procédé de fabrication selon la présente invention va être décrit ci-après dans le cadre d'une filière technologique de fabrication de composants CMOS utilisée par la Société STMicroelectronics et désignée sous l'appellation HCMOS6. Dans cette filière, il existe un niveau de silicium polycristallin et cinq niveaux de métallisation parmi lesquels le premier niveau de métallisation est une couche de tungstène et les niveaux de métallisation suivants sont des couches d'aluminium. Aux emplacements où l'on veut faire établir des contacts entre niveaux de métallisation, on creuse des vias, qui sont remplis de tungstène. Le dépôt de tungstène par voie chimique en phase vapeur à partir de WF₆ est classiquement précédé du dépôt d'une couche de titane (40 nm) et d'une couche de nucléation de nitrure de titane (100 nm).

Comme le représente la figure 1, on considère une tranche semiconductrice en cours de fabrication dont la surface supérieure est revêtue d'une couche isolante 10, qui est une couche isolante déposée à la suite de la formation d'un ou plusieurs niveaux conducteurs, par exemple la première couche isolante déposée après le dernier niveau de silicium polycristallin, ou une couche isolante de niveau supérieur.

Au-dessus de cette couche isolante est formée une couche de métallisation gravée en des emplacements choisis, pour laisser en place par exemple une région étendue 12 destinée à former la première plaque d'un condensateur et une région étroite 13 avec laquelle on veut établir un contact par l'intermédiaire d'un via. Après gravure, le niveau de métallisation comprenant les régions 12 et 13 est revêtu d'une couche isolante 15 destinée à servir d'isolant entre niveaux de métallisation, qui est une couche relativement épaisse (quelques centaines de nanomètres) et de constante diélectrique faible.

Selon l'invention, la couche 15 est d'abord gravée uniquement au-dessus des régions où l'on veut former des condensateurs. On dépose ensuite une couche isolante mince 17 qui correspond au diélectrique du condensateur et qui doit donc être aussi mince que possible tout en gardant une épaisseur constante et en ne présentant pas de failles pour éviter tout claquage de condensateur et destruction du composant. Le matériau de la couche 17 a de préférence une constante diélectrique élevée.

De préférence, pour faciliter le dépôt de la couche isolante 17 et améliorer sa fiabilité, l'ouverture dans la couche isolante 15 au-dessus de la plaque d'électrode 12 est formée de façon à présenter des parois inclinées. Ceci peut par exemple être obtenu par une gravure ionique réactive (RIE) sous plasma en présence de NF₃. Diverses méthodes pourront être utilisées pour améliorer cet aspect incliné des parois de l'ouverture. On pourra par exemple utiliser des masques successifs. Tout procédé connu pour réaliser cette gravure à flancs inclinés de la couche isolante 15 pourra être utilisé.

A l'étape illustrée en figure 2, on part de la structure illustrée en figure 1 et l'on grave une ouverture étroite 20 au-dessus de la région 13 avec laquelle on veut établir un contact vers la métallisation de niveau supérieur. Cette ouverture doit être une ouverture à flancs raides pour minimiser la surface occupée. Ceci peut par exemple être obtenu par une gravure ionique réactive (RIE) sous plasma en présence de CHF₃ ou de SF₆.

A l'étape illustrée en figure 3, on a déposé une couche d'accrochage 22, classiquement par dépôt successif de Ti et de TiN, après quoi on a déposé une couche de tungstène 24 suffisamment épaisse pour remplir complètement l'ouverture 20. On notera que les étapes réalisées en relation avec la figure 3 sont les étapes classiques de remplissage d'un via dans une filière technologique classique telle que la filière HCMOS6. On utilise ces étapes de remplissage de via pour former simultanément au-dessus de la zone de condensateur une région de tungstène.

Ensuite, on procède à une étape de polissage mécano-chimique non représentée pour éliminer la partie de la couche de tungstène 24 qui se trouve au-dessus du niveau des couches isolantes 15 et 17. On enlève éventuellement aussi la partie de la couche d'accrochage 22 située sous la partie de couche de tungstène enlevée. Enfin, on dépose un niveau de métallisation suivant. Ce niveau de métallisation résulte par exemple du dépôt successif d'une couche mince de titane et d'une couche d'aluminium-cuivre. Après quoi, on définit des régions 31 et 32. La région 31 correspond, avec la région restante de la couche 24, à la deuxième électrode du condensateur au-dessus de la première électrode 12. La région 32 établit un contact avec le via formé dans l'ouverture 20. On obtient ainsi la structure illustrée en figure 4.

Pour donner des ordres de grandeur pratiques, la largeur de l'ouverture 20 d'un via entre deux niveaux de métallisation est par exemple de l'ordre de 0,4 µm. Par contre, les dimensions latérales de l'ouverture correspondant au condensateur sont beaucoup plus grandes, par exemple de l'ordre de 400 à 800 µm. On notera que la figure n'est pas à l'échelle et que la région de condensateur est beaucoup plus étendue que cela n'est représenté par rapport aux vias.

Le procédé de fabrication selon la présente invention présente de nombreux avantages.

Selon un premier avantage, il implique très peu d'étapes supplémentaires par rapport à un procédé de fabrication classique de composants CMOS dans lequel aucun condensateur n'est prévu. Les seules étapes supplémentaires résident dans l'ouverture de la couche 15 au-dessus des régions de condensateur et le dépôt de la couche isolante 17. Toutes les autres étapes de masquage et de dépôt sont utilisées de façon classique. Incidemment, on notera que la présence de la couche d'oxyde 17 présente un avantage supplémentaire en ce qu'elle marque bien la fin de gravure mécano-chimique réalisée entre les étapes des figures 3 et 4. Ainsi, non seulement le procédé permet de réaliser des condensateurs, mais en plus il améliore le procédé classique de formation de vias.

Un deuxième avantage de la présente invention réside dans le fait que les flancs des ouvertures de condensateur, dans lesquelles est déposée la couche isolante mince destinée à former le diélectrique du condensateur, sont inclinés, d'où il résulte que les angles inférieurs de cette couche sont peu susceptibles de présenter des défauts.

Un autre avantage de la présente invention apparaît dans le cas de la filière HCMOS6 utilisée par la société STMicroelectronics dans laquelle la première couche de métallisation dont est formée la région 12 est une couche de tungstène et dans laquelle les vias sont remplis de tungstène. Etant donné que les régions 12 et 24 sont toutes deux en tungstène, quand la température du composant varie, il ne se produit pas de contraintes de dilatation différentielle de part et d'autre de la couche isolante 17, ce qui se produirait si les couches de part et d'autre étaient en des métaux différents.

Un autre avantage de l'utilisation de tungstène est que ce matériau peut supporter des températures élevées, allant jusqu'à 700°C. On peut alors déposer la couche isolante 17 à une température de l'ordre de 700°C. Par contre, si la couche inférieure était une couche d'aluminium, on ne pourrait dépasser une température de l'ordre de 400°C. Or, en pratique, il est connu que la qualité d'une couche isolante mince est meilleure quand son dépôt est effectué à température plus élevée.

On a ainsi obtenu un composant fiable, à faible capacité parasite avec les éléments du substrat, et à faible résistance d'accès, étant donné que le tungstène est un matériau dont la conductivité est relativement élevée.

La présente invention est susceptible de diverses variantes et modifications qui apparaîtront à l'homme de l'art, notamment en ce qui concerne le choix de matériaux et la réalisation pratique d'étapes particulières. Par exemple, la couche isolante 17 pourra être en oxyde de silicium, en nitrure de silicium, ou en un autre isolant choisi, ou encore en une combinaison d'isolants.

## Revendications

1. Procédé de fabrication d'un condensateur dans des niveaux de métallisation d'un circuit intégré comprenant les étapes successives suivantes:
déposer un premier niveau de métal et graver ce premier niveau de métal pour laisser en place au moins une région (12) correspondant à une première plaque d'un condensateur et au moins une zone de contact (13) correspondant à une connexion avec laquelle on veut établir un contact supérieur ;
déposer une couche isolante (15) entre niveaux de métallisation ;
former une première ouverture au-dessus de la première plaque de condensateur (12) ;
déposer une couche isolante mince (17) ;
former une deuxième ouverture (20) au-dessus de la zone de contact ;
déposer un deuxième niveau de métal (24) de façon à remplir complètement la deuxième ouverture (20) ;
**caractérisé en ce qu'**il comprend les étapes successives suivantes: procéder à une gravure physico-chimique pour éliminer la deuxième couche de métal en dehors des régions où elle remplit les ouvertures ;
déposer un troisième niveau de métal et laisser en place des portions (31, 32) de ce troisième niveau de métal au-dessus de ladite région de condensateur et de ladite zone de contact.

2. Procédé selon la revendication 1, **caractérisé en ce que** les premier et deuxième niveaux de métal sont en tungstène.

3. Procédé selon la revendication 1, **caractérisé en ce que** la première ouverture est réalisée de façon à présenter des flancs inclinés tandis que la deuxième ouverture est réalisée de façon à présenter des flancs raides.

4. Procédé selon la revendication 2, **caractérisé en ce que** le troisième niveau de métal est en Al-Cu.

## Claims

1. A method of forming a capacitor in metallization levels of an integrated circuit comprising the following successive steps:
depositing a first metallization level and engraving this first metallization level in order to leave at least one region (12) corresponding to a first plate of a capacitor in place and at least one contact area (13) corresponding to a connection with which one wishes to establish a higher-level contact;
depositing an isolation layer (15) between metallization levels ;
forming a first opening above the first capacitor plate (12);
depositing a thin isolation layer (17);
forming a second opening (20) above the contact area;
depositing a second metallization level (24) so as to completely fill up the second opening (20);
**characterized in that** the method comprises the following steps:
proceeding to a physio-chemical engraving operation in order to eliminate the second metallization layer outside regions where it fills up the openings;
depositing a third metallization level and leaving portions (31, 32) of this third metallization level in place above said capacitor region and said contact area.

2. A method as claimed in claim 1, **characterized in that** the first and second metallization levels are made of tungsten.

3. A method as claimed in claim 1, **characterized in that** the first opening is provided in order to present inclined edges while the second opening is provided in order to present steep edges.

4. A method as claimed in claim 2, **characterized in that** the third metallization level is made of Al-Cu.

## Patentansprüche

1. Fertigungsverfahren eines Kondensators in Metallisierungsstufen eines integrierten Kreislaufes, der die nachstehenden aufeinander folgenden Etappen umfasst:
- Ablagerung einer ersten Metallstufe und Gravur dieser ersten Metallstufe zur Freilassung zumindest eines Bereichs (12), der einer ersten Kondensatorplatte entspricht, und zumindest eines Berührungsbereichs (13), der einer Verbindung entspricht, mit der eine höhere Berührung hergestellt werden kann;
- Ablagerung einer Isolierschicht (15) zwischen den Metallisierungsebenen;
- Ausbildung einer ersten Öffnung über der ersten Kondensatorplatte (12);
- Ablagerung einer dünnen Isolierschicht (17);
- Ausbildung einer zweiten Öffnung (20) über dem Berührungsbereich;
- Ablagerung einer zweiten Metallebene (24) derart, dass die zweite Öffnung (20) vollständig ausgefüllt wird;
**dadurch gekennzeichnet, dass** es die nachstehenden aufeinander folgenden Etappen umfasst:
- Ausführung einer physikalisch-chemischen Gravur zur Beseitigung der zweiten Metallschicht außerhalb der Bereiche, in denen sie die Öffnungen ausfüllt;
- Ablagerung einer dritten Metallebene und Freilassung von Abschnitten (31, 32) dieser dritten Metallebene über dem genannten Kondensatorbereich und dem genannten Berührungsbereich.

2. Verfahren nach Anspruch 1, **dadurch gekennzeichnet, dass** die erste und die zweite Metallebene aus Wolfram sind.

3. Verfahren nach Anspruch 1, **dadurch gekennzeichnet, dass** die erste Öffnung derart ausgeführt wird, dass sie geneigte Flanken aufweist, währenddessen die zweite Öffnung derart ausgeführt wird, dass sie steife Flanken aufweist.

4. Verfahren nach Anspruch 2, **dadurch gekennzeichnet, dass** die dritte Metallebene Al-Cu ist.
